# EUROPEAN PATENT APPLICATION

(11) **EP 4 716 412 A1**
(43) Date of publication of application: **25.03.2026**
(21) Application number: 24217932.3
(22) Date of filing: 06.12.2024
(51) Int. Cl.: H10D 89/60

(54) **DIODE TRIGGERED SILICON CONTROLLED RECTIFIERS**

(30) Priority: 18.09.2024 US 202418888712
(71) Applicant: GlobalFoundries U.S. Inc., Malta, NY 12020 (US)
(72) Inventor: KARALKAR, Sagar Premnath, Essex Junction, VT 05452 (US); JAIN, Vibhor, Essex Junction, VT 05452 (US); LOISEAU, Alain François, Essex Junction, VT 05452 (US)
(74) Representative: Lambacher, Michael

(57) **Abstract**

The present disclosure relates to semiconductor structures and, more particularly, to diode triggered silicon controlled rectifiers and methods of manufacture. The structure includes: a vertical silicon controlled rectifier (SCR) having a doped semiconductor material region over a semiconductor substrate; and at least one vertical triggering diode electrically connected to the SCR in series, and having a doped semiconductor material region over a doped region in the semiconductor substrate.

## Description

### BACKGROUND

The present disclosure relates to semiconductor structures and, more particularly, to diode triggered silicon controlled rectifiers and methods of manufacture.

Silicon controlled rectifiers (SCRs) are used for electrostatic discharge (ESD) protection of integrated circuits (ICs) from the sudden flow of electricity caused by, for example, contact, electrical shorts, or dielectric breakdown. Because of high current handling ability per unit area of an SCR, ESD devices utilizing an SCR can protect ICs from failure. These devices are most often used in high performance analog and radiofrequency (RF) designs for chips that have large signal swings, low leakage, and low capacitance. Due to the capacitance loading and poor harmonics of SCRs, RF performance may be impacted.

### SUMMARY

In an aspect of the disclosure, a structure comprises: a vertical silicon controlled rectifier (SCR) comprising a doped semiconductor material region over a semiconductor substrate; and at least one vertical triggering diode electrically connected to the SCR in series, and comprising a doped semiconductor material region over a doped region in the semiconductor substrate.
Additional features of the structure are set forth in dependent claims 2 to 11.

In an aspect of the disclosure, a structure comprises: a vertical silicon rectifier (SCR) comprises a doped SiGe region; and a series of vertical diodes in series with the SCR, the series of vertical diodes comprising a triggering PN junction and a doped SiGe region.
Additional features of the structure are set forth in dependent claims 13 and 14.

In an aspect of the disclosure, a method comprises: forming a vertical silicon controlled rectifier (SCR) comprising a doped semiconductor material region over a semiconductor substrate; and forming at least one vertical triggering diode electrically connected to the SCR in series, and comprising a doped semiconductor material region over a doped region in the semiconductor substrate.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a diode triggered silicon control rectifier (SCR) and respective fabrication processes in accordance with aspects of the present disclosure.
FIGS. 2-7 show diode triggered SCRs and respective fabrication processes in accordance with additional aspects of the present disclosure.
FIGS. 8A-8D show cross-sectional views of steps in the fabrication processes of the diode triggered SCR of FIG. 1 in accordance with further aspects of the present disclosure.

### DETAILED DESCRIPTION

The present disclosure relates to semiconductor structures and, more particularly, to diode triggered silicon controlled rectifiers (SCRs) and methods of manufacture. More specifically, the diode triggered SCRs comprise a vertical SCR with a SiGe region and one or more diodes for triggering the SCR. The triggering diodes also include a SiGe region. Depending on the particular embodiment, the SiGe region of the SCR and the triggering diodes may have the same or different doping types. In addition, the triggering diodes may be vertical triggering diodes positioned over a shallow trench isolation structure. In embodiments, the diode triggered SCRs may be used as ESD devices. Advantageously, the diode triggered silicon controlled rectifiers provide early turn on of the diodes helping in triggering the SCR earlier (for low voltage device protection). The diode triggered silicon controlled rectifiers also provide a smaller footprint compared to conventional diode triggered devices.

The diode triggered SCRs of the present disclosure can be manufactured in a number of ways using a number of different tools. In general, though, the methodologies and tools are used to form structures with dimensions in the micrometer and nanometer scale. The methodologies, i.e., technologies, employed to manufacture the diode triggered SCRs of the present disclosure have been adopted from integrated circuit (IC) technology. For example, the structures are built on wafers and are realized in films of material patterned by photolithographic processes on the top of a wafer. In particular, the fabrication of the diode triggered SCRs uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

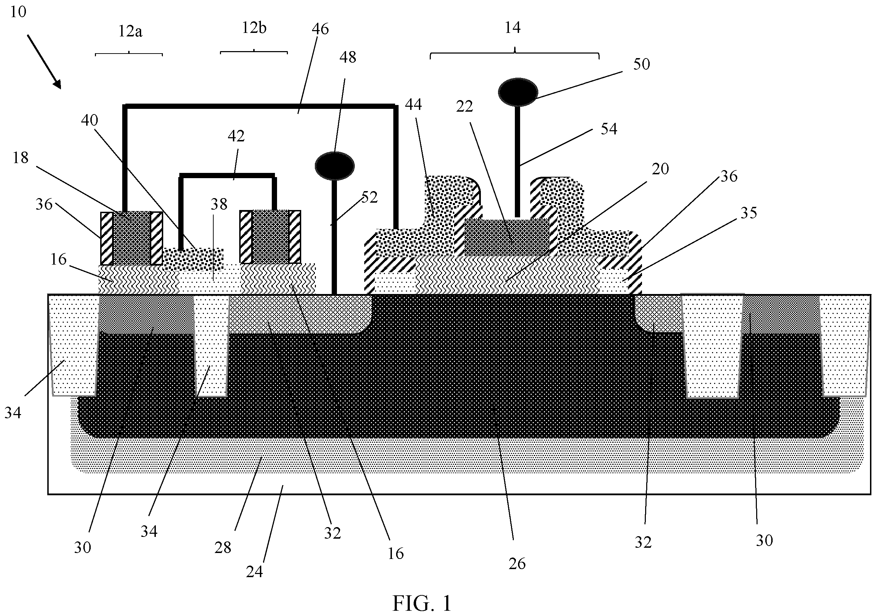

FIG. 1 shows a diode triggered silicon control rectifier (SCR) and respective fabrication processes in accordance with aspects of the present disclosure. In particular, the structure 10 of FIG. 1 shows diodes 12a, 12b connecting to an SCR 14 in series. In embodiments, each of the diodes 12a, 12b may be vertical triggering diodes comprising, for example, SiGe material 16 and polysilicon material 18. Similarly, the SCR 14 may be a vertical SCR which comprises SiGe material 20 and polysilicon material 22. The SiGe material 16 of the diodes 12a, 12b and the SiGe material 20 of the SCR 14 may be doped with a same dopant type and, more specifically, may be doped with n-type dopants. For example, the n-type dopants of the SiGe material 16, 20 may be, e.g., Arsenic (As), Phosphorus (P) and Antimony (Sb), among other suitable examples. In this way, the SiGe material 16, 20 are the same materials and can be formed in the same processing steps. The polysilicon material 18, 22 may be doped with a p-type dopant, e.g., Boron. The polysilicon material 18, 22 may be emitters for the diodes 12a, 12b and the SCR 14.

In more specific embodiments, the structure 10 of FIG. 1 includes a semiconductor substrate 24. The semiconductor substrate 24 may be a bulk substrate of a semiconductor-on-insulator (SOI) substrate as is known in the art such that no further explanation is required for a complete understanding of the present disclosure. The semiconductor substrate 24 may be composed of any suitable semiconductor material including, but not limited to, Si, SiGe, SiGeC, SiC, GaAs, InAs, InP, and other III/V or II/VI compound semiconductors. In further embodiments, the semiconductor substrate 24 may be a p-type substrate.

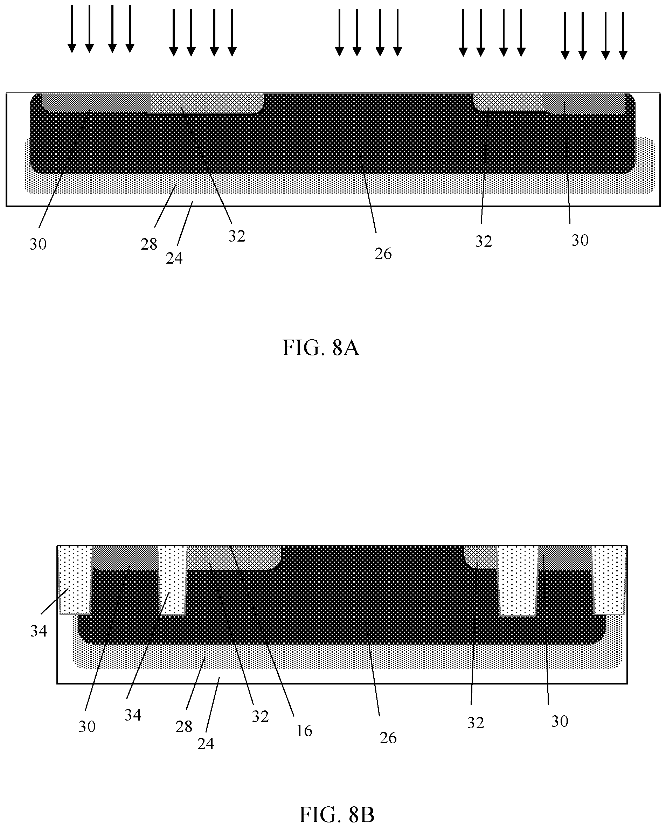

In embodiments, the semiconductor substrate 24 includes a P-well 26. An optional deep well 28 may be used to isolate the P-well 26 from the semiconductor substrate 24. Implant regions 30, 32 may be formed in the P-well 26. In embodiments, the implant regions 30, 32 may also surround the SCR 14. The implant region 30 may be a p-type region; whereas the implant region 32 may be an n-type region. The wells 26, 28 and implant regions 30, 32 may be formed by conventional ion implantation processes by introducing a concentration of a different dopants of different conductivity types and concentrations in the semiconductor substrate 24 as described in FIG. 8A.

The implant regions 30, 32 may be separated or isolated from one another by shallow trench isolation structures 34 extending into the P-well 26. In embodiments, the shallow trench isolation structures 34 may also be formed at the edges of the P-well 26, which surround and isolate the P-well 26, SCR 14 and diodes 12a, 12b from other structures. The shallow trench isolation structures 34 can be formed by conventional lithography, etching and deposition methods known to those of skill in the art and as further described with respect to FIG. 8B.

Still referring to FIG. 1, the diode 12a may be over (e.g., directly on) the implant region 30 and the diode 12b may be over (e.g., directly on) the implant region 32. As previously disclosed, the diodes 12a, 12b may be vertical triggering diodes connected in series. The diodes 12a, 12b may each comprise, for example, SiGe material 16 and polysilicon material 18. The SiGe material 16 and polysilicon material 18 may be formed by conventional epitaxial growth processes with an in-situ doping. For example, the SiGe material 16 may be doped with n-type dopants and the polysilicon material 18 may be doped with p-type dopants. In this way, the diodes 12a, 12b comprise a triggering PN junction (above the shallow trench isolation structures 34). Similarly, the SCR 14 may include SiGe material 20 and polysilicon material 22, both of which are formed in the same manner with the same dopant types as the diodes 12a, 12b. In embodiments, the SCR 14 may be a PNPN, e.g., p-type polysilicon material 22, n-type SiGe material 20, P-well 26 and n-type implant region 32.

The diodes 12a, 12b and SCR 14 may also include sidewall spacers 36. In embodiments, the sidewall spacers 36 isolate the SiGe material 16, 20 and polysilicon material 18, 22 from other structures of the device. The sidewall spacers 36 may be formed by conventional deposition processes, e.g., CVD, followed by an anisotropic etching process as is known in the art. As an example, the sidewall spacers 36 may be an oxide material, nitride material or combinations thereof. In addition, the diodes 12a, 12b may be separated or isolated from one another by insulator material 38. In embodiments, the insulator material 38 may be an interlevel dielectric material such as oxide or nitride or combinations thereof. Additionally, insulator material 35 may be formed on the sidewalls of the SiGe material 20 of the SCR 14. The insulator material 35 may be oxide or nitride or combinations thereof, as an example.

A semiconductor material 40 may be located on the diode 12a and, more particularly, may be in electrical contact (e.g., direct contact) with the SiGe material 16 of the diode 12a. In embodiments, the semiconductor material 40 may be a base region, for example, comprising n-doped SiGe material; although other semiconductor materials are also contemplated herein. The semiconductor material 40 of the diode 12a may be electrically connected to the diode 12b, e.g., the polysilicon material 18 of the diode 12b, using a wiring structure 42. The wiring structure 42 may any back end of the line wiring structure such as, for example, copper, aluminum, tungsten, etc. In this way, the diodes 12a, 12b are a string of diodes connected in series. It should be understood by those of skill in the art that more than two diodes can be strung together in a manner similar to that shown in FIG. 1.

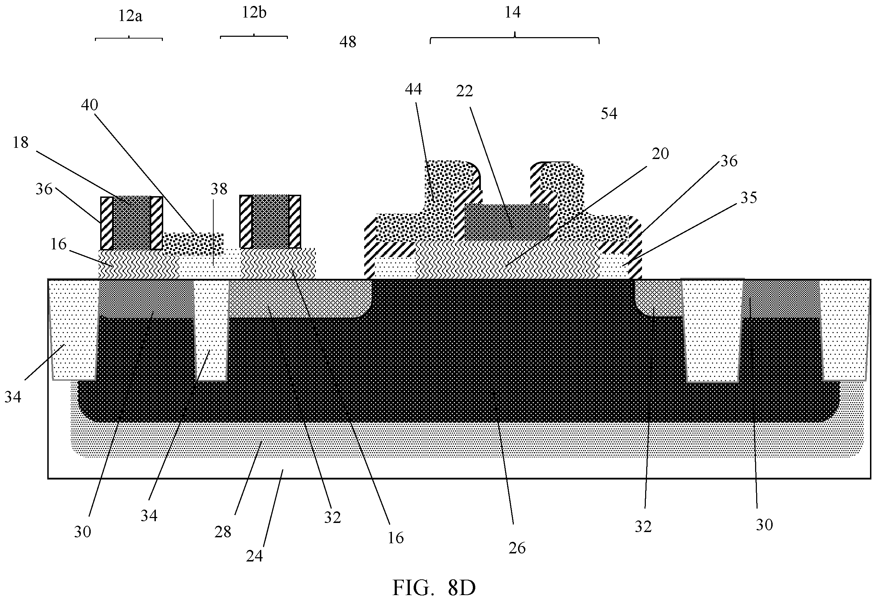

FIG. 1 further shows a semiconductor material 44 electrically connected (e.g., directly on) to the SiGe material 20 of the SCR 14. In embodiments, the semiconductor material 44 may be any semiconductor material and, preferably, may be n-doped SiGe material. The semiconductor material 44 allows electrical connection between the string of diodes 12a, 12b and the SCR 14. For example, the semiconductor material 44 may be electrically connected to the diode 12a and, more specifically, the polysilicon material (e.g., emitter) 18 of the diode 12a by a wiring structure 46. In addition, the diode 12b may be shunted to the implant region 32 and may connect to a cathode 48 using a wiring structure 52. On the other hand, the SCR 14 may be connected to an anode 50. In embodiments, the polysilicon material 22 of the SCR 14 connects to the anode 50 using a wiring structure 54. Prior to forming the wiring structures 42, 46, 52, 54, the exposed semiconductor materials may undergo a silicide process to form silicide contacts as further described with respect to FIG. 8D.

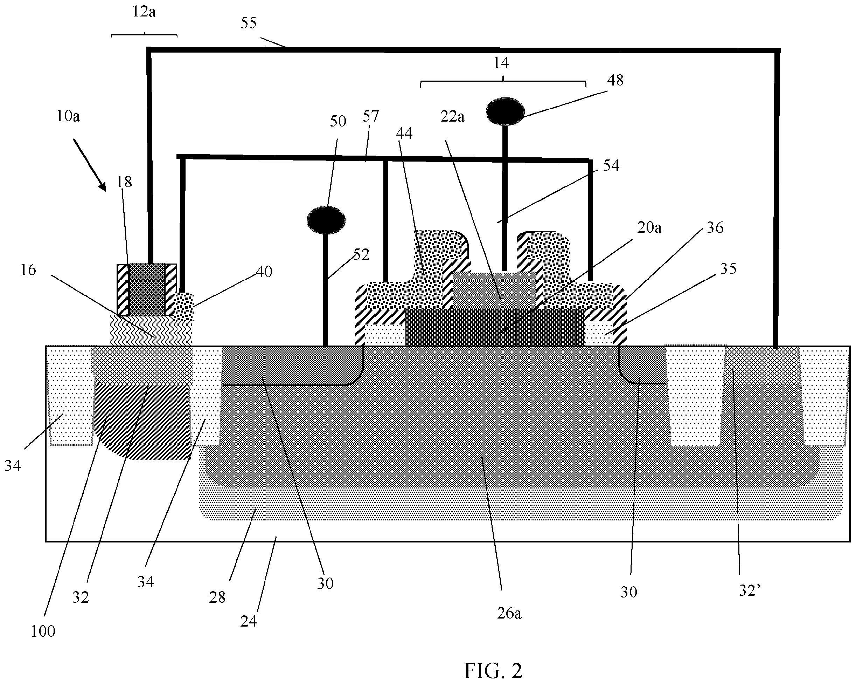

FIG. 2 shows a diode triggered silicon control rectifier (SCR) in accordance with additional aspects of the present disclosure. In particular, the structure 10a of FIG. 2 shows a single diode 12a connecting to the SCR 14 in series. In embodiments, the diode 12a is over the implant region 32, e.g., n-implant region, and is electrically connected to the implant region 32', e.g., n-implant region, and the SCR 14. The diode 12a may be connected to the implant region 32' by wiring structure 55 and electrically connected to the SCR 14 by wiring structure 57. In this embodiment, the implant regions 30, 32' may be in an N-well 26a. Similarly, the SCR 14 may be over the N-well 26a. Also, in this embodiment, the diode 12a includes SiGe material 16 with an n-type dopant and polysilicon material 18 with a p-type dopant; whereas the SCR 14 includes SiGe material 20a with a p-type dopant and polysilicon 22a with an n-type dopant. Moreover, the SCR 14 may be electrically connected to the anode 50, and the cathode 48 is electrically connected to the implant region 30. In embodiments, the implant region 32, e.g., p-implant region, may be optional provided in a p-well 100. In the case of the implant region 32 being optional, the diode 12a will be over the p-well, e.g., the SiGe material 16 will be over the p-well 100. The P-well 100 may also be optional.

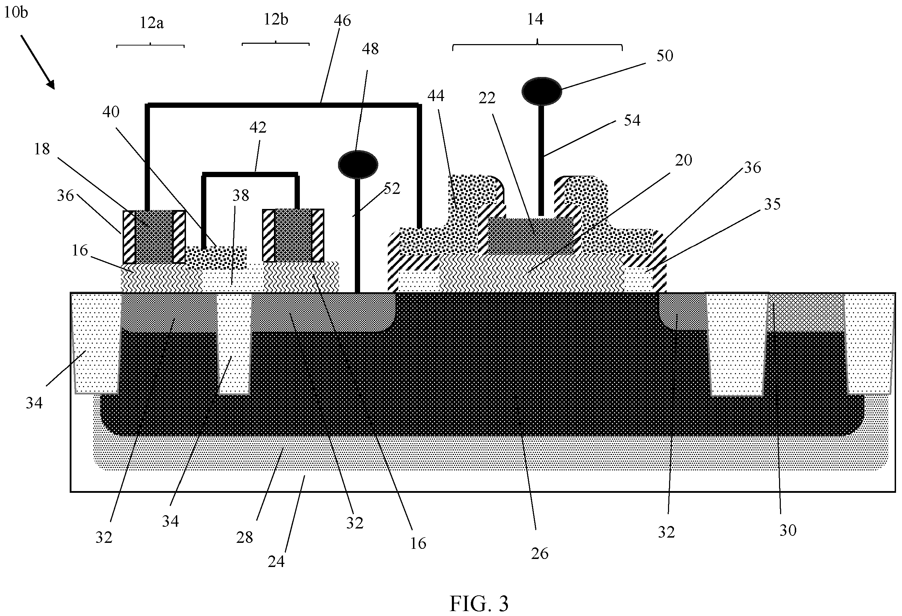

FIG. 3 shows a diode triggered silicon control rectifier (SCR) in accordance with additional aspects of the present disclosure. In particular, the structure 10b of FIG. 3 shows the diodes 12a, 12b in series, and both being over implant regions 32, e.g., n-implant region. The remaining features of the structure 10b are similar to the structure 10 of FIG. 1 such that no further explanation is required for a complete understanding of the present disclosure.

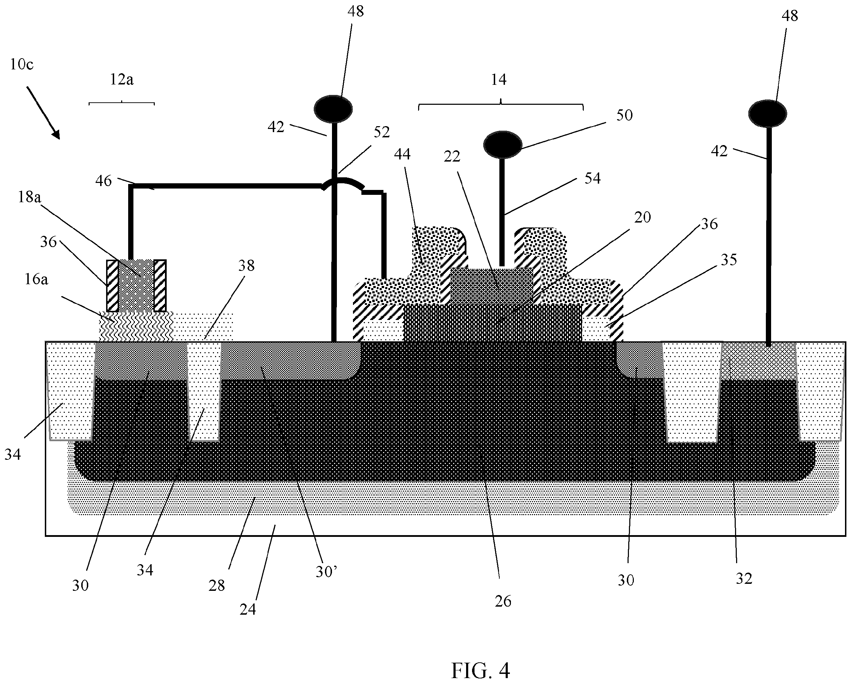

FIG. 4 shows another diode triggered silicon control rectifier (SCR) in accordance with aspects of the present disclosure. In particular, the structure 10c of FIG. 4 shows the diode 12a in series with the SCR 14, and being over the implant region 30, e.g., n-implant region. In this embodiment, the diode 12a (e.g., polysilicon material 18a) is connected (electrical connection) to the semiconductor material 44. The implant region 32 (p+ region) and the implant region 30' (n-implant region) are connected to the cathode 48 by the wiring structure 42. Also, the diode 12a includes SiGe material 16a with a p-type dopant and polysilicon material 18a with an n-type dopant; whereas the SCR 14 includes SiGe material 20 with an n-type dopant and polysilicon material 22 with a p-type dopant. The SCR 14 may be electrically connected to the anode 50. The diode 12a may also be electrically connected to the SCR 14 by wiring structure 46. The remaining features of the structure 10c are similar to the structure 10 of FIG. 1 such that no further explanation is required for a complete understanding of the present disclosure.

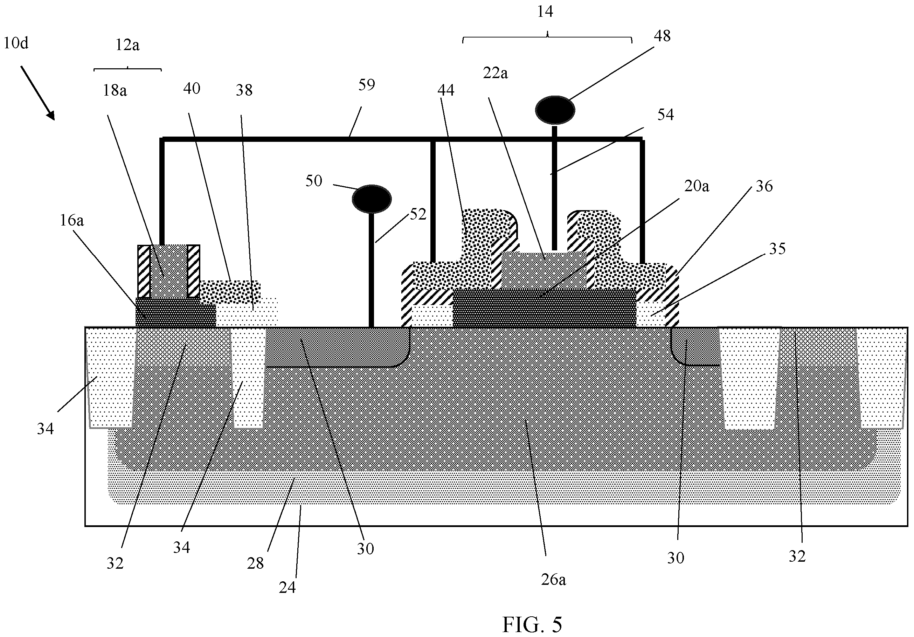

FIG. 5 shows another diode triggered silicon control rectifier (SCR) in accordance with aspects of the present disclosure. In particular, the structure 10d of FIG. 5 shows a single diode 12a connecting to the SCR 14 in series. In embodiments, the diode 12a may be over the implant region 32, e.g., n-implant region, and may be electrically connected to the SCR 14. In further embodiment, the implant region 32 may be connected to a bottom surface of SiGe material 16a with a p-type dopant. The diode 12a may be electrically connected to the SCR 14 by wiring structure 59. Also, in this embodiment, the implant regions 30, 32 may be in an N-well 26a, with the SCR 14 sitting over the N-well 26a. Also, in this embodiment, the diode 12a includes SiGe material 16a with a p-type dopant and polysilicon material 18a with a n-type dopant. Similarly, the SCR 14 comprises SiGe material 20a with an n-type dopant and polysilicon 22a with a p-type dopant. Moreover, the SCR 14 is electrically connected to the cathode 48, and the anode 50 is electrically connected to the implant region 30, e.g., p-type implant. The remaining features of the structure 10d are similar to the structure 10b of FIG. 2 such that no further explanation is required for a complete understanding of the present disclosure.

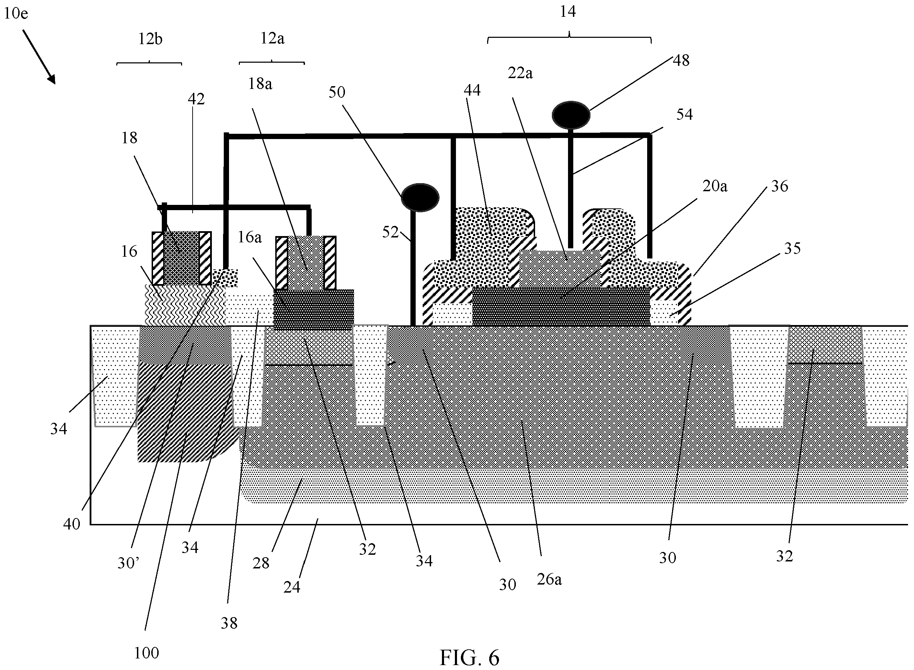

FIG. 6 shows another diode triggered silicon control rectifier (SCR) in accordance with aspects of the present disclosure. In particular, the structure 10e of FIG. 6 shows diodes 12a, 12b connecting to the SCR 14, all in series. For example, in embodiments, the diodes 12a, 12b are connected in series by wiring structure 42, with the diode 12b connecting to the SCR 14 in series. In embodiments, the diodes 12a, 12b are over the implant region 30, 32. For example, diode 12a may be over implant region 32, e.g., n-implant region, and diode 12b may be over implant region 30', e.g., p-implant region. The implant regions 30, 32 may be in an N-well 26a, the SCR 14 may sit over the N-well 26a and the p-well 30' may be in a p-well 100. The p-well 100 may be optional.

In the embodiment of FIG. 6, the diode 12a includes SiGe material 16a with a p-type dopant and polysilicon material 18a with an n-type dopant; whereas the diode 12b includes SiGe material 16 with an n-type dopant and polysilicon material 18 with a p-type dopant. SCR 14 includes SiGe material 20a with an n-type dopant and polysilicon 22a with a p-type dopant. In embodiments, the implant region 32 may be connected to a bottom surface of SiGe material 16a with a p-type dopant. Moreover, the SCR 14 is electrically connected to the cathode 50, and the anode 48 is electrically connected to the implant region 30, e.g., p-type implant. The implant region 30 is separated from the n-type implant region 32 by a shallow trench isolation structure 34. Also, as embodiments, the implant region 30, e.g., p-implant region, may be optional provided in a p-well 100. In the case of the implant region 30 being optional, the SCR 12b will be over the p-well, e.g., the SiGe material 16 will be over the p-well 100. The p-well may also be optional. The remaining features of the structure 10d are similar to the structure 10d of FIG. 5 such that no further explanation is required for a complete understanding of the present disclosure.

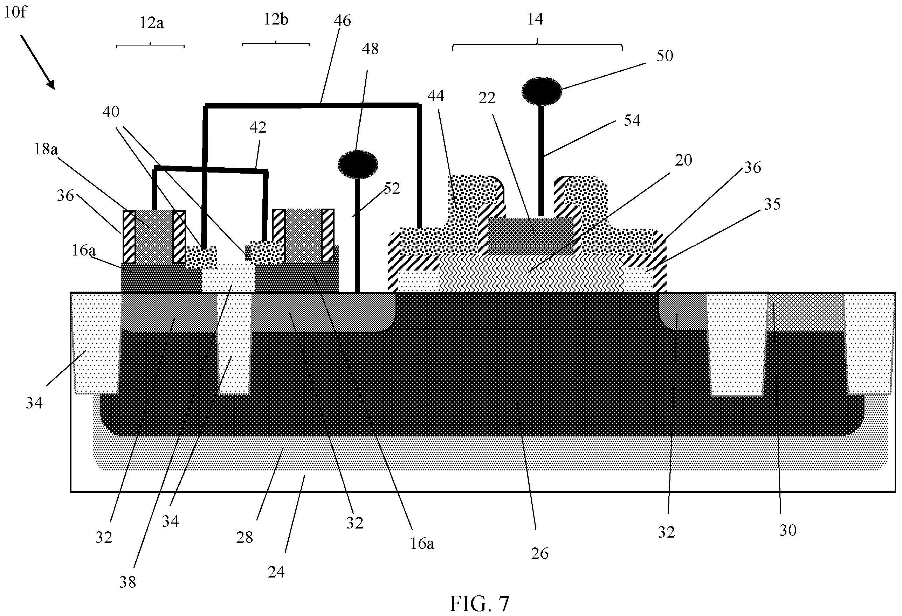

FIG. 7 shows another diode triggered silicon control rectifier (SCR) in accordance with aspects of the present disclosure. In particular, the structure 10f of FIG. 7 shows diodes 12a, 12b connecting in series, and both being over implant regions 32, e.g., n-implant region. In this embodiment, the diodes 12a, 12b include polysilicon material 18a, e.g., n-type poly material, over SiGe material 16a with a p-type dopant. The extrinsic base, e.g., semiconductor material 40, may be p-type semiconductor material. Moreover, in this embodiment, the polysilicon material 18a of the diode 12a is connected to the extrinsic base, e.g., semiconductor material 40, of the diode 12b by wiring layer 44. Also, the polysilicon material 18a of the diodes 12b is connected to the semiconductor material 44 of the SCR 14 by wiring layer 46. The remaining features of the structure 10f are similar to the structure 10b of FIG. 3 such that no further explanation is required for a complete understanding of the present disclosure.

FIGS. 8A-8D show cross-sectional views of steps in the fabrication processes of the diode triggered SCR of FIG. 1 in accordance with further aspects of the present disclosure. As should be understood by those of skill in the art, similar processes described herein can also be used to fabricate any of the different structures of FIGS. 2-7by using different dopant types and patterning masks in different configurations in order to block epitaxial growth processes to prevent formation of different diodes in a string of diodes.

FIG. 8A shows the formation of the wells 26, 28 and implant regions 30, 32 formed by conventional ion implantation processes. In these processes, a concentration of a different dopants of different conductivity types and concentrations are introduced into the semiconductor substrate 24. In embodiments, respective patterned implantation masks may be used to define selected areas exposed for the implantations. The implantation mask used to select the exposed area for forming any of the wells 26, 28 and implant regions 30, 32 are stripped after implantation, and before the implantation mask used to form another of the wells 26, 28 and implant regions 30, 32. The implantation masks may include a layer of a light-sensitive material, such as an organic photoresist, applied by a spin coating process, pre-baked, exposed to light projected through a photomask, baked after exposure, and developed with a chemical developer. Each of the implantation masks has a thickness and stopping power sufficient to block masked areas against receiving a dose of the implanted ions. The P-well 26 and p-implant region 30 may be doped with p-type dopants, e.g., Boron (B), and the N-well 28 and n-implant region 32 may be doped with n-type dopants, e.g., Arsenic (As), Phosphorus (P) and Antimony (Sb), among other suitable examples.

FIG. 8B shows the formation of the shallow trench isolation structures 34 extending into the P-well 26. It should be recognized by those of skill in the art, the shallow trench isolation structures 34 may be formed prior to or after the formation of the implant regions 30, 32. The shallow trench isolation structures 34 can be formed by conventional lithography, etching and deposition methods known to those of skill in the art. For example, a resist formed over the semiconductor substrate 24 is exposed to energy (light) and developed utilizing a conventional resist developer to form a pattern (opening). An etching process with a selective chemistry, e.g., reactive ion etching (RIE), will be used to transfer the pattern from photoresist layer to form one or more trenches in the semiconductor substrate 24 through the openings of the resist. Following the resist removal by a conventional oxygen ashing process or other known stripants, the insulator material (e.g., silicon dioxide) can be deposited by any conventional deposition processes, e.g., chemical vapor deposition (CVD) processes. Any residual material on the surface of the semiconductor substrate 24 can be removed by conventional chemical mechanical polishing (CMP) processes.

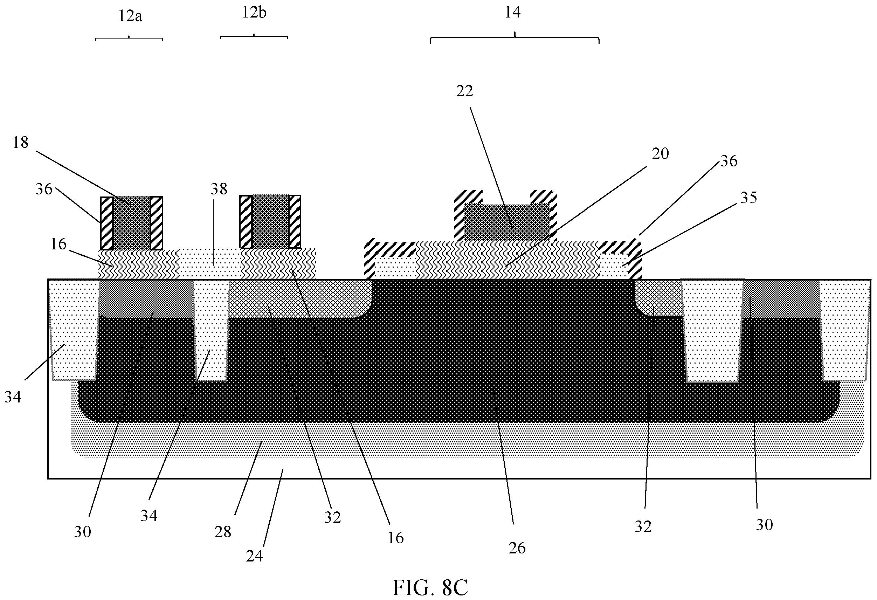

FIG. 8C shows the formation of the diodes 12a, 12b and the SCR 14. In particular, the diodes 12a, 12b and the SCR 14 may be formed by an epitaxial growth process in which SiGe material 16, 20 is epitaxial grown over the implant regions 30, 32 and the P-well 26. The polysilicon material 18, 22 may be epitaxial grown over the SiGe material 16, 20. In embodiments, the epitaxial growth may be used with or without the aid of masks, e.g., oxide and pad nitrides, depending on the desired configuration. The semiconductor material 44 may be formed over exposed portions of the SiGe material 20 using epaxial growth processes as already described herein.

Examples of various epitaxial growth process apparatuses that can be employed in the present application include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth may be performed at a temperature of from 300° C. to 800° C. The epitaxial growth can be performed utilizing any well-known precursor gas or gas mixture. Carrier gases like hydrogen, nitrogen, helium and argon can be used. A dopant (n-type or p-type, as defined above) may be added to the precursor gas or gas mixture. The sidewall spacers 36 may be formed by conventional deposition processes, e.g., CVD, followed by an anisotropic etching process as is known in the art.

In FIG. 8D, the semiconductor material 40 may be formed over the exposed portion of the semiconductor material 16. Prior to forming the wiring structures 42, 46, 52, 54, the exposed semiconductor materials may undergo a silicide process to form silicide contacts. As should be understood by those of skill in the art, the silicide process begins with deposition of a thin transition metal layer, e.g., nickel, cobalt or titanium, over fully formed and patterned semiconductor material (e.g., polysilicon material 18, 22, implant region 32 and semiconductor material 44). After deposition of the material, the structure is heated allowing the transition metal to react with the exposed semiconductor material as described herein forming a low-resistance transition metal silicide. Following the reaction, any remaining transition metal is removed by chemical etching, leaving silicide contacts in the active regions of the device.

The wiring structures 42, 46, 52, 54, may be formed by conventional back of the line processes. For example, and referring back to FIG. 1, an interlevel dielectric material may be deposited over the structure using conventional deposition processes, e.g., a blanket CVD process. The interlevel dielectric material may be, for example, oxide material, nitride materials or combination of layers thereof. Patterns, e.g., trenches, are formed in the interlevel dielectric material to expose the underlying semiconductor material, e.g., polysilicon 18, 22, semiconductor material 40 and portions of the implant region 30. The patterning can be formed by conventional lithography and etching, e.g., RIE, processes as already described herein. A metal material, e.g., tungsten, aluminum, copper and/or different alloys as is known in the art, may be deposited within the trenches, followed by a chemical mechanical planarization (CMP) process to remove any excess metal material on the surface of the interlevel dielectric material.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a vertical silicon controlled rectifier (SCR) comprising a doped semiconductor material region over a semiconductor substrate; and
at least one vertical triggering diode electrically connected to the SCR in series, and comprising a doped semiconductor material region over a doped region in the semiconductor substrate.

2. The structure of claim 1, wherein the at least one vertical triggering diode and the SCR comprise same semiconductor material with a same dopant type, sitting above a well of a different dopant type within the semiconductor substrate.

3. The structure of claim 2, wherein the semiconductor material with the same dopant type comprises SiGe with a first dopant type, with additional semiconductor material of a second dopant type over the SiGe with the first dopant type.

4. The structure of claim 3, wherein the first dopant type comprises n-dopant and the second dopant type comprises p-dopant and the well comprises p-dopant, or wherein the first dopant type comprises p-dopant and the second dopant type comprises n-dopant and the well comprises n-dopant.

5. The structure of one of claims 1 to 4, wherein the at least one vertical triggering diode comprises multiple vertical triggering diodes electrically connected in series with the SCR, and/or wherein the SCR comprises a PNPN.

6. The structure of claim 5, wherein:
a first vertical triggering diode of the at least one vertical triggering diode sits on an n-doped region within the p-well;
a second vertical triggering diode of the at least one vertical triggering diode sits on a p-doped region within the p-well; and
the first vertical triggering diode, the second vertical triggering diode and the SCR are connected in series.

7. The structure of claim 5, wherein:
a first vertical triggering diode of the at least one vertical triggering diode sits on a first n-doped region within the p-well;
a second vertical triggering diode of the at least one vertical triggering diode sits on a second n-doped region within the p-well; and
the first vertical triggering diode, the second vertical triggering diode and the SCR are connected in series.

8. The structure of claim 1, wherein the at least one vertical triggering diode comprises semiconductor material with a first dopant type, the SCR comprises the semiconductor material with a second dopant type, and the at least one vertical triggering diode and the SCR sit over a well of the first dopant type.

9. The structure of claim 8, wherein the first dopant type comprises p-dopant and the second dopant type comprises n-dopant and the well comprises p-dopant, or wherein the first dopant type comprises n-dopant and the second dopant type comprises p-dopant and the well comprises n-dopant.

10. The structure of claim 3, wherein a first triggering diode of the multiple vertical triggering diodes sits on an n-doped region in a n-well, a second triggering diode of the multiple vertical triggering diodes sits on a p-doped region in the n-well, the p-doped region connects to an anode and the SCR connects to a cathode.

11. The structure of claim 10, wherein the first dopant type comprises p-dopant and the second dopant type comprises n-dopant and the well comprises n-dopant.

12. A structure comprises:
a vertical silicon rectifier (SCR) comprises a doped SiGe region; and
a series of vertical diodes in series with the SCR, the series of vertical diodes comprising a triggering PN junction and a doped SiGe region.

13. The structure of claim 12, wherein the doped SiGe region of the SCR and the doped SiGe region of the vertical diodes comprises n-type dopants, and further comprising the SCR and the series of vertical diodes sitting over a p-well, and, optionally, wherein a first of the vertical diodes are over an n-type doped region in the p-well and a second of the vertical diodes are over a p-type doped region in the p-well, or wherein the vertical diodes are over an n-type doped region in the p-well.

14. The structure of claim 12, wherein the doped SiGe region of the SCR and a first vertical diode of the vertical diodes comprises p-type dopants, and a second vertical diode of the vertical diodes comprise n-type dopants.

15. A method comprising:
forming a vertical silicon controlled rectifier (SCR) comprising a doped semiconductor material region over a semiconductor substrate; and
forming at least one vertical triggering diode electrically connected to the SCR in series, and comprising a doped semiconductor material region over a doped region in the semiconductor substrate.
